(19) **Europäisches Patentamt**

**European Patent Office**

**Office européen des brevets**

(11) Veröffentlichungsnummer: **0 489 889 B1**

(12) **EUROPÄISCHE PATENTSCHRIFT**

(45) Veröffentlichungstag der Patentschrift: **02.11.94**

(21) Anmeldenummer: **91912151.7**

(22) Anmeldetag: **27.06.91**

(86) Internationale Anmeldenummer:
**PCT/DE91/00533**

(87) Internationale Veröffentlichungsnummer:
**WO 92/01079 (23.01.92 92/03)**

(51) Int. Cl.⁵: **C23C 14/28**

(54) **VERFAHREN ZUR ABSCHEIDUNG DÜNNER SCHICHTEN MITTELS LASERIMPULS-GASPHASENABSCHEIDUNG (LPVD).**

(30) Priorität: **03.07.90 DD 342456**
**03.07.90 DD 342455**

(43) Veröffentlichungstag der Anmeldung:
**17.06.92 Patentblatt 92/25**

(45) Bekanntmachung des Hinweises auf die
Patenterteilung:
**02.11.94 Patentblatt 94/44**

(84) Benannte Vertragsstaaten:
**DE FR GB**

(56) Entgegenhaltungen:
**DE-C- 3 914 476**

(73) Patentinhaber: **FRAUNHOFER-GESELLSCHAFT ZUR FÖRDERUNG DER ANGEWANDTEN FORSCHUNG E.V.**
**Leonrodstrasse 54**
**D-80636 München (DE)**

(72) Erfinder: **Mai, Hermann**
**Wallstrasse 21**
**O-8010 Dresden (DE)**
Erfinder: **Dietsch, Reiner**
**Fr.-Hegel-Strasse 19**
**O-8027 Dresden (DE)**
Erfinder: **Schubert, Klaus**
**Schulstrasse 1**
**W-8218 Possendorf (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 489 889 B1

## Beschreibung

Die Erfindung bezieht sich auf das Gebiet der Optik, insbesondere Röntgenoptik, und der Mikroelektronik. Sie findet Anwendung in LPVD-Anlagen zur Herstellung dünner und dünnster Schichten.

Nach WP C 23 C/338 176 8 DD bzw. EP-A-0 445 897 wird das Target, das eine gekrümmte Oberfläche besitzt, bei fixierter Lage des Impulslaserstrahles zeilenweise in X-Richtung in gleichmäßigen Schritten $\Delta X$ aus der Mittellage $X_o$ in beide Richtungen ausgelenkt, so daß die sich in radialer Richtung ausbreitende Plasmafackel mit ihrem Intensitätamaximum die gesamte Substratoberfläche überstreichen kann. Die einzelnen Zeilen werden durch Verschiebung des Targets in Y-Richtung eingestellt.

Die Mängel dieses Verfahrens bestehen darin, daß einerseits Inhomogenitäten in der Schichtdickeverteilung auftreten, da die Abscheiderate in dem der Targetmitte gegenüberliegenden Gebiet der Substratoberfläche größer als in den Randgebieten ist und andererseits ein ungleichmäßiger Targetabtrag entsteht, was eine Veränderung der Targetkrümmung zur Folge hat. Die Ursache für beide Mängel ist in der Laserleistungsdichteänderung als Funktion der Auslenkung aus der Mittellage $X_o$ zu suchen, was daraus resultiert, daß durch die gekrümmte Targetoberfläche mit steigender Auslenkung aus der Mittellage $X_o$ die Größe des im Laserfokus liegenden Target-Flächenelements zunimmt.

Das Ziel der Erfindung besteht in einem Verfahren zur Abscheidung dünner Schichten mittels LPVD, bei dem keine Inhomogenitäten in der Schichtdickeverteilung auftreten und ein gleichmäßiger Targetabtrag zu verzeichnen ist.

Der Erfindung liegt die Aufgabe zugrunde, ein Verfahren zur Abscheidung dünner Schichten mittels LPVD anzugeben, bei dem die Laserleistungsdichteänderung als Funktion der Auslenkung aus der Mittellage $X_o$ vermieden oder kompensiert wird. Erfindungsgemäß wird die Aufgabe dadurch gelöst, daß wie in den Ansprüchen 1 bis 4 verfahren wird.

Durch die Strahlbewegung, wie sie in den Ansprüchen 1 bis 3 beschrieben ist, wird die durch die Targetkrümmung verursachte Zunahme der Größe des im Laserstrahlfokus liegenden Target-Flächenelementes mit steigender Auslenkung aus der Mittellage ausgeschlossen. Damit ist auch keine Abnahme der Laserleistungsdichte als Funktion der Auslenkung aus der Mittellage $X_o$ mehr zu verzeichnen. Außerdem wird ein Defokussierung des Systems während der Abscheidung durch dieses Verfahren verhindert.

Mit der Verfahrensweise von Anspruch 4 erfolgt die Auslenkung des Targets in X-Richtung so, daß die durch die Zunahme des im Laserstrahlfokus liegenden Target-Flächenelementes verursachte Abnahme der Laserleistungsdichte auf dem Target durch eine variable Schrittweite $\Delta X$ und durch eine variable Anzahl der Laserimpulse pro Targetpunkt kompensiert wird. Durch eine zusätzliche Änderung des Linsen-Target-Abstandes (Nachführung des Targets in Z-Richtung) wird eine Defokussierung des Systeme verhindert.

Die Erfindung soll an nachfolgenden Ausführungsbeispielen näher erläutert werden.

## 1. Ausführungsbeispiel

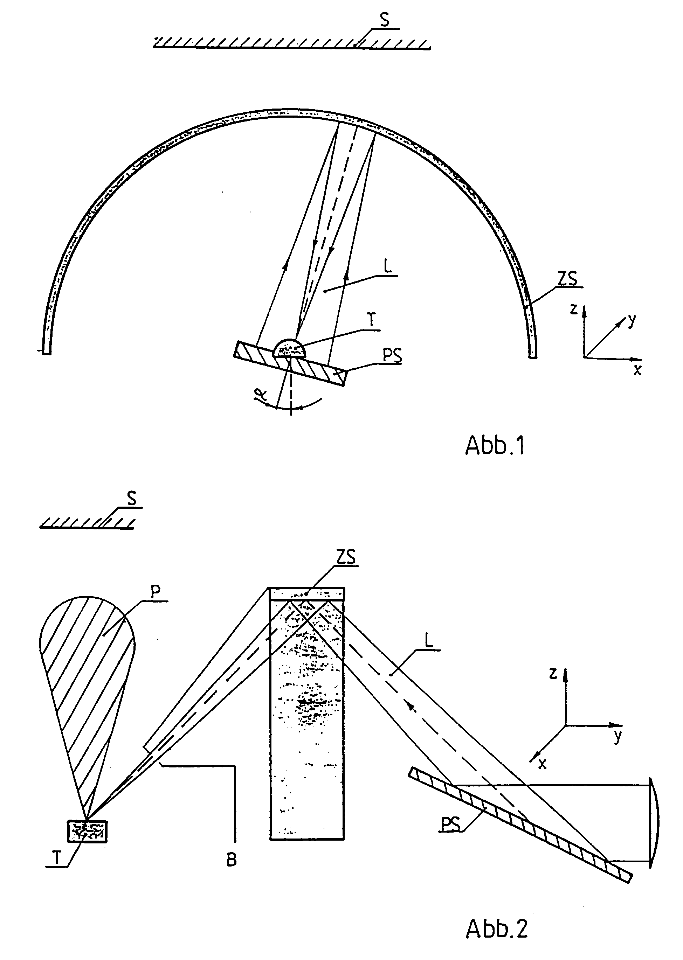

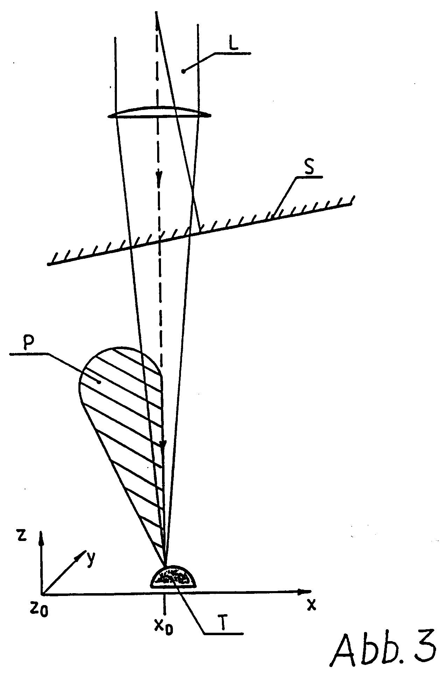

Das erfindungsgemäße Verfahren der Ansprüche 1 bis 3 ist in Abb. 1 (Draufsicht) und in Abb. 2 (Seitenansicht) näher erläutert.

Auf einem ebenen Substrat S mit den Abmessungen 70 mm x 20 mm soll eine Metallschicht abgeschieden werden, deren Schichtdickenunterschiede über die gesamte Oberfläche 1 ... 10 % sind. Dazu wird das Substrat S im Abstand von mehreren Zentimetern gegenüber einem zylinderförmigen Target T mit einem Durchmesser und einer Länge von jeweils 10 mm so angeordnet, daß die Querachse des Substrates S in Richtung der Zylinderachse zeigt und die sich in radialer Richtung ausbreitende Plasmafackel P mit ihrem Intensitätsmaximum die gesamte Substratoberfläche überstreichen kann. Vor Beginn der Abscheidung ist die Anordnung so zu justieren, daß die Oberflächennormalen von Target- und Substratmitte in einer Geraden liegen und der Impulselaserstrahl L auf den Targetmittelpunkt fokussiert ist. Synchron zur Freqenz des Impulslasers erfolgt die Bewegung des Impulslaserstrahles L auf dem Zylinderspiegel ZS and damit auf der Oberfläche des Targets T durch eine schrittweise Kippung des Planspiegels PS um den Kippwinkel $\alpha$. Der Betrag der Kippung pro Schritt beträgt in der Mittellage 1,7 Grad. Mit steigender Gesamtkippung aus der Mittellage verringert sich $\Delta\alpha$ proportional zu $\cos^2\alpha$. Der maximale Kippwinkel $\alpha$ beträgt 38,5 Grad. Damit ergeben sich bei Auslenkung nach beiden Seiten aus der Mittellage ca. 70 Impulse pro Spur. Durch Verschiebung des Targets T in Y-Richtung um einen Betrag von $\Delta Y = 0,5$ mm wird die nächste Spur eingestellt. Bei einer Targetlänge von 10 mm werden 17 Spuren durchgeführt. Um eine starke Bedampfung des Zylinderspiegels ZS zu vermeiden, wird dieser mit einer Schlitzblende B vor dem Laserdampf geschützt. Die nach dem dargelegten Verfahren auf dem Substrat S abgeschiedene Schicht wies Schichtdickenunterschiede von ca. 5 % auf.

## 2. Ausführungsbeispiel

In Abb. 3 ist eine mögliche Anordnung zur Durchführung des erfindungsgemäßen Verfahrens gemäß Anspruch 4 schematisch dargestellt.
Auf einem ebenen Substrat S mit den Abmessungen 70 mm x 20 mm soll eine Metallschicht abgeschieden werden, deren Schichtdickenunterschiede über die gesamte Oberfläche 1 ... 10 % sind. Dazu wird das Substrat S in einem Abstand von mehreren Zentimetern gegenüber einem zylinderförmigen Target T mit einem Durchmesser und einer Länge von jeweils 10 mm so angeordnet, daß die Querachse des Substrates S in Richtung der Zylinderachse zeigt, und die sich in radialer Richtung ausbreitende Plasmafackel P mit ihrem Intensitätsmaximum die gesamte Substratoberfläche überstreichen kann. Vor Beginn der Abscheidung ist die Anordnung so zu justieren, daß die Oberflächennormalen von Target- und Substratmitte in einer Geraden liegen und der Impulslaserstrahl L auf den Targetmittelpunkt fokussiert ist. Synchron zur Frequenz des Impulslasers erfolgt die Bewegung des Impulslaserstrahles L auf der gekrümmten Targetoberfläche durch eine schrittweise Verschiebung des Targets T in X-Richtung. Der Betrag pro Schritt der Auslenkung in X-Richtung beträgt in der Mittellage $X_o$ ca. 0,2 mm. Mit steigender Auslenkung aus der Mittellage $X_o$ verringert sich $\Delta X$ proportional zu $\cos^2 \alpha$, wobei $\alpha$ = arc sind $\frac{X}{r}$ (r = Targetradius). Die maximale Auslenkung aus der Mittellage beträgt 4 mm. Zur weiteren Verbesserung der Gleichmäßigkeit der Schichtdicke werden eine Verdoppelung der Impulszahl pro Fläche bei einer Auslenkung oberhalb 2 mm sowie eine Nachführung des Targets T in Z-Richtung durchgeführt. Durch Verschiebung des Targets T in Y-Richtung um einen Betrag von $\Delta Y$ = 0,5 mm wird die nächste Spur eingestellt. Bei einer Targetlänge von 10 mm ergibt sich somit eine Anzahl von max. 17 Spuren. Die nach dem dargelegten Verfahren auf dem Substrat S abgeschiedene Schicht wies Schichtdickenunterschiede von ca. 5 % auf.

## Aufstellung der verwendeten Bezugszeichen und Begriffe

S -  Substrat
L -  Impulslaserstrahl
T -  Target
PS -  Planspiegel
ZS -  Zylinderspiegel
B -  Schlitzblende für Zylinderspiegel
$\alpha$ -  Kippwinkel des Planspiegels
P -  Plasmafackel

## Patentansprüche

1. Verfahren zur Abscheidung dünner Schichten mittels Laserimpuls-Gasphasenabscheidung (LPVD), dadurch gekennzeichnet, daß der auf die Oberfläche eines gekrümmten Targets (T) fokussierte Impulslaserstrahl (L) über einen drehbar gelagerten Planspiegel (PS) und einen Zylinderspiegel (ZS) geführt wird, die Bewegung des Impulslaserstrahles (L) auf der gekrümmten Oberfläche des Targets (T) durch die Kippung des Planspiegels (PS) um eine in Strahlrichtung durch die durch seine Oberfläche aufgespannte Ebene verlaufende Achse erfolgt, die Kippung schrittweise erfolgt und die Einstellung der Abtragspuren auf dem Target (T) in bekannter Weise durch Verschiebung des Targets (T) in Y-Richtung erfolgt.

2. Verfahren nach Anspruch 1, dadurch gekennzeichnet, daß der Zylinderspiegel (ZS) mit einer Schlitzblende (B) vor einem Bedampfen geschützt wird.

3. Verfahren nach Anspruch 1, dadurch gekennzeichnet, daß der Betrag der Kippung pro Schritt $\Delta\alpha$ über die Gesamtkippung entsprechend der gewünschten Schichtdickenverteilung als korrigierte Funktion des Inkrementes von der Gesamtgröße $\alpha$ ausgeführt wird.

4. Verfahren zur Abscheidung dünner Schichten mittels Laserimpuls-Gasphasenabscheidung (LPVD), dadurch gekennzeichnet daß synchron zur Bewegung des Impulslaserstrahles (L) auf der gekrümmten Oberfläche des Targets (T) eine Schwenkung des Substrates (S) erfolgt und entweder die lineare Targetbewegung durch eine nichtlineare Targetbewegung ersetzt wird, indem zunächst die Auslenkung des Targets (T) in X-Richtung erfolgt, wobei mit zunehmender Auslenkung des Targets (T) aus der Mittellage $X_o$ die Schrittweite $\Delta X$ zu verringern und die Anzahl der Laserimpulse zu erhöhen sind, zusätzlich eine Änderung des Linsen-Target-Abstandes erfolgt und die Einstellung der Abtragspuren auf dem Target (T) durch Verschiebung des Targets (T) in Y-Richtung erfolgt oder unter Beibehaltung der linearen Targetbewegung eine entsprechende Änderung der Energiedichte des Impulslaserstrahles (L) in Abhängigkeit von der Auslenkung aus der Mittellage $X_o$ durch Änderung der Impulsenergie bzw. des Linsen-Target-Abstandes erfolgt und die Einstellung der Abtragspuren auf dem Target (T) in bekannter Weise durch Verschiebung des Targets (T) in Y-Richtung erfolgt.

**Claims**

1. Method for the deposition of thin layers by laser pulse vapour deposition (LPVD), characterised in that the pulsed laser beam (L), which is focused onto the surface of a curved target (T), is guided by a rotatably mounted plane mirror (PS) and a cylinder mirror (ZS), the movement of the pulsed laser beam (L) on the curved surface of the target (T) takes place by the tilting of the plane mirror (PS) about an axis extending in the beam direction through the plane fixed by its surface, the tilting takes place stepwise, and adjustment of the cutting tracks on the target (T) takes place in a known manner by displacement of the target (T) in the Y-direction.

2. Method according to claim 1, characterised in that the cylinder mirror (ZS) is protected from vapour deposition with a slotted diaphragm (B).

3. Method according to claim 1, characterised in that the amount of tilting per step $\Delta\alpha$ over the total tilting is executed according to the desired layer thickness distribution as a corrected function of the increment of the total quantity $\alpha$.

4. Method for the deposition of thin layers by laser pulse vapour deposition (LPVD), characterised in that in synchronisation with the movement of the pulsed laser beam (L) on the curved surface of the target (T), pivoting of the substrate (S) takes place and either the linear target movement is replaced by a non-linear target movement by the fact that first deflection of the target (T) in the X-direction takes place, wherein with increasing deflection of the target (T) from the centre position $X_0$ the step size $\Delta X$ is to be decreased and the number of laser pulses is to be increased, in addition variation of the lens-to-target distance takes place and adjustment of the cutting tracks on the target (T) takes place by displacement of the target (T) in the Y-direction, or, while retaining the linear target movement, a corresponding variation of the energy density of the pulsed laser beam (L) takes place as a function of the deflection from the centre position $X_0$ by varying the pulse energy or the lens-to-target distance and adjustment of the cutting tracks on the target (T) takes place in a known manner by displacement of the target (T) in the Y-direction.

**Revendications**

1. Procédé de dépôt de couches minces par impulsions laser en phase gazeuse (LPVD), **caractérisé** en ce qu'on fait passer le faisceau laser impulsionnel (L), focalisé sur la surface d'une cible courbe (T), par un miroir plan (PS) monté à rotation et par un miroir cylindrique (ZS), on déplace le faisceau laser impulsionnel (L) sur la surface courbe de la cible (T) en faisant basculer le miroir plan (PS) autour d'un axe s'étendant dans la direction du faisceau dans le plan engendré par sa surface, le basculement s'effectuant pas à pas, et on règle les traces d'enlèvement de matière sur la cible (T), d'une manière connue, en déplaçant la cible (T) dans la direction Y.

2. Procédé selon la revendication 1, **caractérisé** en ce que le miroir cylindrique (ZS) est protégé d'une métallisation par un diaphragme à fente (B).

3. Procédé selon la revendication 1, **caractérisé** en ce que la valeur du basculement par pas $\Delta d$ par rapport au basculement total, conformément à la répartition souhaitée d'épaisseur de couche, est conçue comme fonction corrigée de l'incrément de la valeur totale d.

4. Procédé de dépôt de couches minces par impulsions laser en phase gazeuse (LPVD), **caractérisé** en ce qu'on fait pivoter le substrat (S) en synchronisme avec le déplacement du faisceau laser impulsionnel (L) sur la surface courbe de la cible (T) et, soit on remplace le déplacement linéaire de la cible par un déplacement non linéaire de la cible, en faisant d'abord dévier la cible (T) dans la direction X, la largeur de pas $\Delta X$ devant être augmentée et le nombre d'impulsions laser diminué avec l'augmentation de la déviation de la cible (T) par rapport à la position médiane $X_0$, en modifiant en outre la distance entre la cible et la lentille et en réglant les traces d'enlèvement de matière sur la cible (T) en déplaçant la cible (T) dans la direction Y, soit, en conservant le déplacement linéaire de la cible, on modifie la densité énergétique du faisceau laser impulsionnel (L) en fonction de la déviation par rapport à la position médiane $X_0$ en modifiant l'énergie impulsionnelle ou la distance entre la cible et la lentille, et on règle les traces d'enlèvement de matière sur la cible (T), d'une manière connue, en déplaçant la cible (T) dans la direction Y.

Abb.1

Abb.2

Abb.3